# EUROPÄISCHE PATENTSCHRIFT

(11) **EP 1 224 482 B1**
(45) Veröffentlichungstag und Bekanntmachung des Hinweises auf die Patenterteilung: **11.05.2005**
(21) Anmeldenummer: 00967604.0
(22) Anmeldetag: 20.09.2000
(51) Int. Cl.: G01R 31/3185

(54) **VERFAHREN UND VORRICHTUNG ZUM DATENSCHÜTZENDEN SELBSTTEST FÜR MIKROKONTROLLER**
METHOD AND DEVICE FOR THE DATA PROTECTING SELF-TEST OF A MICROCONTROLLER
PROCEDE ET DISPOSITIF DE TEST AUTOMATIQUE DE PROTECTION DE DONNEES POUR MICRO-CONTROLEUR

(30) Priorität: 23.09.1999 EP 99118825
(43) Veröffentlichungstag der Anmeldung: 24.07.2002
(73) Patentinhaber: Infineon Technologies AG, 81669 München (DE)
(72) Erfinder: RICHTER, Michael, 85521 Ottobrunn (DE); OTTERSTEDT, Jan, 82008 Unterhaching (DE)
(74) Vertreter: Epping Hermann & Fischer
(86) Internationale Anmeldenummer: PCT/DE2000/003271
(87) Internationale Veröffentlichungsnummer: WO 2001/022106

(56) Entgegenhaltungen:
- EP-A- 0 743 602
- EP-A- 0 798 620
- US-A- 5 570 375
- DATABASE WPI Section EI, Week 198925 Derwent Publications Ltd., London, GB; Class T01, AN 1989-184235 XP002135536 ANONYMOUS: "Self test method for secure LSSD chip - has scan string outputs, clock inputs, test pin and shift gate pin accessible during wafer test" & RESEARCH DISCLOSURE, vol. 301, no. 051, 10 May 1989 (1989-05-10), Emsworth, GB

## Beschreibung

Die Erfindung betrifft ein Verfahren sowie eine Anordnung, in Form einer integrierten Schaltung zum datenschützenden Selbsttest für Microcontroller.

Bei der Herstellung integrierter Schaltungen (IC) ist der Fertigungstest ein die Qualität entscheidend mitbestimmender Aspekt. Im Normalfall werden dazu die integrierten Schaltungen auf einem Testsystem mit einer Vielzahl von Testmustern an den Eingangspins der ICs stimuliert und die Testantworten an den Ausgangspins der ICs gemessen und mit den im Testsystem gespeicherten Sollwerten verglichen.

Ein Problem ergibt sich hieraus für eine bestimmte Klasse von ICs, der sogenannten Sicherheits-ICs, wie sie z.B. für die Datenverschlüsselung oder zur hardwaremäßigen Absicherung von Übertragungsprotokollen eingesetzt werden. Bei diesen ICs unterliegen Aufbau und Funktion bestimmten Sicherheitsanforderungen, die - vereinfacht ausgedrückt - bedingen, daß für Nicht-Berechtigte über die Pins des IC kein Zugang zu den internen Schaltungselementen des IC möglich sein darf. Aus diesem Grund kann hier die geschilderte Testmethodik nicht angewandt werden, da durch die Kenntnis und Speicherung von Eingangsdaten sowie der zugehörigen Soll-Ausgangsdaten in z.B. einem Testsystem oder einem PC Rückschlüsse auf den Aufbau und die Funktion des IC möglich wären. Dennoch muß auch für diese Klasse von ICs ein adäquater Fertigungstest durchgeführt werden.

Zur Lösung dieses Problems sind Selbsttests (BIST, Built-In Self-Test) entwickelt worden. Ein Selbsttest erfordert meist nur die Angabe eines Startsignals; nach einer vorgegebenen Zeit kann dann die im IC aufbereitete Testantwort ausgelesen werden. Da diese Testantwort aus der Komprimierung einer großen Zahl von Einzel-Testergebnissen zu einem einzigen Datensatz besteht, kann in der Regel aus dieser Testantwort kein Rückschluß auf Aufbau und Funktion des IC gezogen werden.

Zur Realisierung eines Selbsttests kann man für Microcontroller zwei verschiedene Ansätze unterscheiden:
- einen Selbsttest, der aus der Ausführung eines im Microcontroller selbst gespeicherten Testprogramms besteht;
- einen Selbsttest, wie er z.B. in IEEE-Standard 1149.1 "Standard Test Access Port and Boundary-Scan Architecture" unter dem Begriff "RUNBIST" als optionale Funktion beschrieben wird.

Der prinzipielle Vorteil eines Selbsttests mittels eines im Microcontroller selbst gespeicherten Testprogramms besteht darin, daß das Testprogramm vor der Durchführung des eigentlichen Tests auf vielfältige Weise die Berechtigung zur Durchführung des Selbsttests prüfen kann. Dies kann u.a. durch externe Eingabe eines Passwortes geschehen, das mit einem im Microcontroller gespeicherten Sollwert verglichen wird, wobei der Selbsttest nur bei positivem Ergebnis der Prüfung gestartet wird.

Jedoch weist der Ansatz über ein im Microcontroller selbst gespeichertes Testprogramm in der Regel erhebliche Nachteile auf. Ein Nachteil ist, daß durch Software nicht alle Schaltungselemente innerhalb des Microcontrollers stimuliert bzw. beobachtet werden können. Dies hat zur Folge, daß die Qualität des Fertigungstests nicht ausreichend hoch ist. Hinzu kommt, daß der erforderliche zusätzlich integrierte Speicher für die Testbefehle die Chipfläche erhöht. Ein weiterer Nachteil ist, daß die Ausführung eines Testprogramms - verglichen mit einem üblichen Test mittels Testautomat - in der Regel um mindestens den Faktor 10 langsamer ist.

Der Ansatz über den Selbsttest mittels des z.B. im IEEE-Standard 1149.1 beschriebenen Boundary Scan löst in der Regel das Problem der Zugänglichkeit interner Schaltungsknoten, da hier alle Ein- und Ausgänge des IC bei der Generierung von Testmustern und Testantworten beteiligt sind. Jedoch erfüllt dieser Selbsttest nur geringe Sicherheitsanforderungen, da die Testmustergenerierung intern abläuft, die Testantworten aber seriell über den Boundary Scan ausgeschoben werden und die Ablaufsteuerung des Selbsttests durch den standardisierten TAP-Controller von außen jederzeit verändert werden kann. So könnte ein "Angreifer" diesen Selbsttest dazu mißbrauchen, um an Geheimnisse im Chip zu gelangen. Dazu würde er den Selbsttest beliebig oft wiederholen, aber die Dauer des Selbsttests durch die Zahl der Taktzyklen, die das System im Zustand "Run-Test/Idle" verharrt, ständig und systematisch variieren und aus den dann jeweils ausgelesenen Ergebnissen Rückschlüsse auf den Chipinhalt ziehen. Die dazu nötigen Steuersignale sind entsprechend dem IEEE-Standard extern frei zugänglich, es gibt keinerlei Schutz gegen derartiges "Ausspionieren".

In Database WPI Section EI, Weak 198925 Derwent Publication Ltd., London, GB; Class T01, AN 1989-184235 XP002135536 Anonymous: "Self test Method ..." & Research Disclosure, Vol. 301, No. 051, 10 May 1989 (1989-05-10), Emsworth GB, ist ein "Onchip" -Selbsttestverfahren beschrieben, welches nur in der Herstellungsphase des Wafers benutzt wird.

In der US-A-5570375 ist ein Mikrocontroller mit "Boundary Scan" beschrieben, wobei ein Signaleingang und ein Signalausgang vorgesehen sind. Mit dem beschriebenen Verfahren wird versucht, den "Hardware Overhead" der Teststreifen zu reduzieren.

EP-A-0798620 beschreibt eine Diebstahlssicherung von Chips mittels im Speicher abgelegten Passwortes.

EP-A-0743602 beschreibt einen Zugangskontrollchip, der nur durch ein Passwort funktioniert.

Aufgabe der Erfindung ist es vor diesem Hintergrund, ein Verfahren und eine Anordnung (in Form einer integrierten Schaltung) anzugeben, die einen vollständigen und schnellen, gegen Angriffe geschützten Selbsttest ermöglichen.

Diese Aufgabe wird erfindungsgemäß mit den in den nebengeordneten Patentansprüchen angegebenen Maßnahmen gelöst.

Bevorzugte Ausführungsformen sind in den Unteransprüchen definiert; vorteilhafte Ausgestaltungen der Erfindung ergeben sich zudem aus der folgenden Beschreibung eines Ausführungsbeispiels.

Der Microcontroller besitzt danach einen Boundary Scan, vorzugsweise entsprechend IEEE-Standard 1149.1. Jedoch sind nur die im IEEE-Standard aufgeführten obligatorischen Testbefehle implementiert, so wie sie nach der Intention des Boundary Scan für den Fertigungstest einer Leiterplatte (und nicht des IC) vorgesehen sind.

Der BIST nutzt nun die Register des Boundary Scan, um Chip-intern pseudo-zufällige Testmuster zu generieren und Testantworten zu komprimieren. Da das Boundary Scan-Register die gesamte Logik des Bausteins bis auf die Ein- und Ausgabezellen umschließt, ist es optimal geeignet, eine maximale Zahl interner Schaltungsknoten über den Selbsttest zu erreichen, was wiederum Voraussetzung für eine möglichst hohe Fehlerüberdekkung und damit Qualität des Fertigungstests ist.

Entsprechend der Erfindung wird dieser BIST jedoch nicht direkt von außen (z.B. über den Befehl "RUNBIST", wie er im IEEE-Standard angegeben ist) gestartet, sondern über den Microcontroller. Der Microcontroller prüft vorab die Berechtigung zur Durchführung des Selbsttests. Während des Selbsttests überwacht der Microcontroller die korrekte Ausführung des Selbsttests, auch indem er keine Unterbrechung des Selbsttests zuläßt. Dazu gehört auch, daß während des BIST über den Boundary Scan keine Testbefehle (entsprechend dem IEEE-Standard) akzeptiert werden, also der im IEEE-Standard angegebene TAP-Controller damit logisch von den Boundary Scan-Zellen abgekoppelt wird. Am Testende kann die komprimierte Testantwort entweder über den Microcontroller ausgegeben oder mit einer in einem Festwertspeicher des Microcontrollers gespeicherten Sollantwort verglichen werden.

Die Erfindung ermöglicht also prinzipiell eine vorteilswahrende Verschmelzung beider bekannten Ansätze und der damit verbundenen logischen Abfolge. Zunächst prüft das im Microcontroller integrierte Testprogramm die Berechtigung für die Ausführung des Selbsttests. Ist diese Bedingung erfüllt, startet das Testprogramm den Selbsttest, indem die Steuersignale des TAP-Controllers logisch vom Boundary Scan-Register abgekoppelt werden, die Testlogik in einen definierten Anfangszustand gesetzt und der Selbsttest gestartet wird. Am Testende liest das Testprogramm die im Boundary Scan-Register gespeicherte Testantwort in einen internen Speicher und löscht anschließend die Testantwort im Boundary Scan-Register. Danach wird der TAP-Controller wieder freigegeben. Die im Microcontroller gespeicherte Testantwort kann nun je nach Implementierung mit einer im Testprogramm abgelegten Sollantwort verglichen oder nach extern ausgegeben werden.

Durch diesen Ablauf wird sichergestellt, daß nur Berechtigte den Selbsttest ausführen können, daß der Ablauf des Selbsttests über die externen Pins nicht verändert werden kann und daß keine Zwischenergebnisse über die Pins nach extern gelangen. Dennoch ist ein schneller vollständiger Selbsttest unter Einbeziehung aller Elemente des Microprozessors ermöglicht.

Im folgenden wird beispielhaft eine bevorzugte Ausführungsform der Erfindung anhand der beigefügten Zeichnungen näher erläutert.

Darin zeigen:
- Figur 1: ein Blockdiagramm eines Microcontrollers;
- Figur 2: ein Ablaufdiagramm für eine bevorzugte Ausführungsform der Erfindung;
- Figur 3: eine Schaltung für eine Eingangs-Boundary Scan-Zelle zur Erzeugung von Testmustern;
- Figur 4: eine Schaltung für einen Ausgangs-Boundary Scan-Zelle zur Aufnahme von Testantworten und
- Figur 5: den prinzipiellen Signalfluß bei der Ausführungsform gemäß Fig. 2 bis 4.

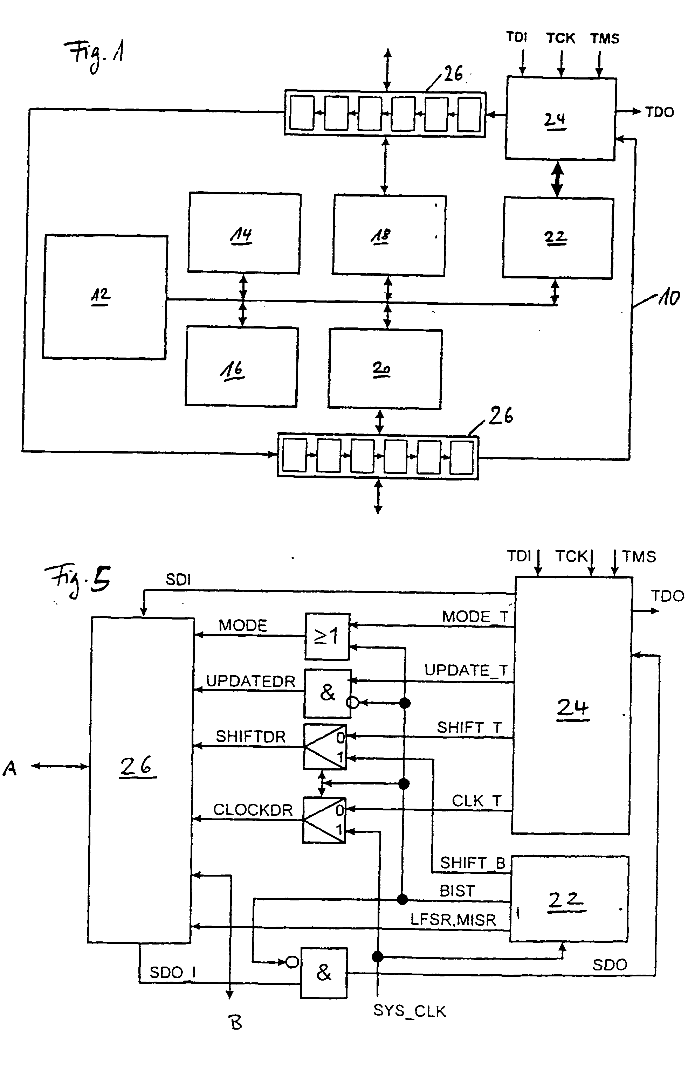

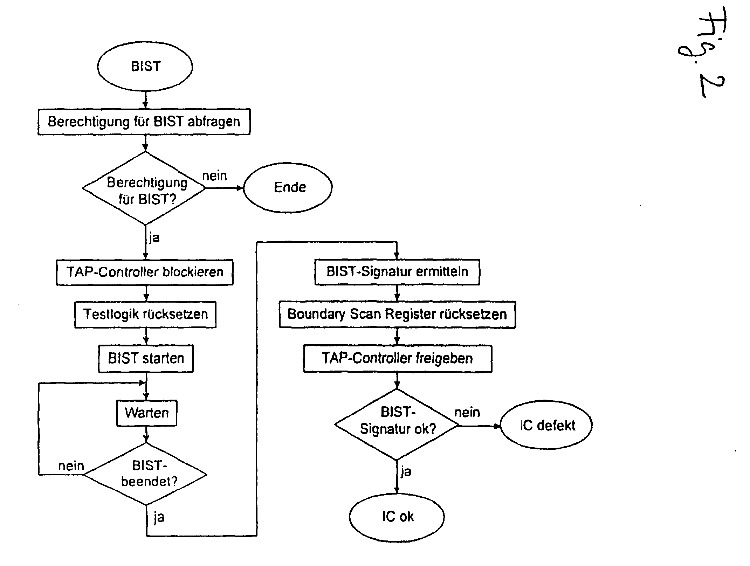

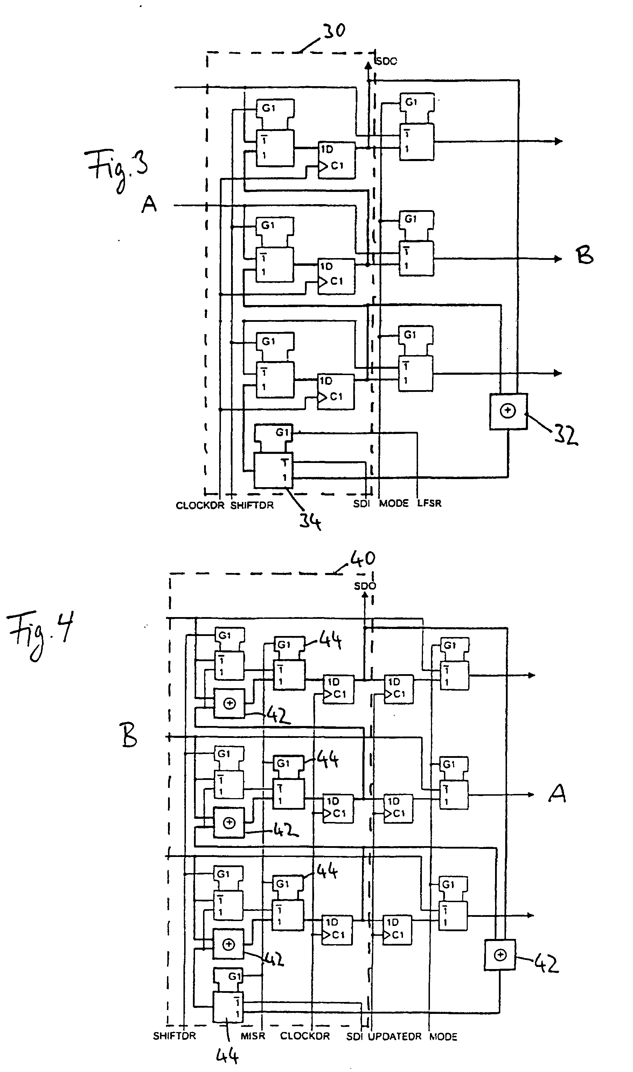

Fig. 1 zeigt ein Blockdiagramm eines Microcontrollers 10 mit Boundary Scan, bestehend aus CPU 12, RAM 14, ROM 16, Ein-/Ausgabeeinheit 18, Peripherieeinheiten (z.B. Timer, Co-Prozessoren) 20, BIST-Controller 22, Boundary Scan TAP-Controller 24, sowie Boundary Scan-Zellen 26. Diese kommunizieren mit den Pads (A in Fig. 3 und 4) und dem Schaltungskern (B in Fig. 3 und 4).

Fig. 2 zeigt ein Beispiel für den logischen Ablauf des Selbsttests. Die Aufforderung an den Microcontroller 10, den Selbsttest zu starten, kann auf verschiedene Weise erfolgen: durch ein externes Signal, durch einen Befehl, der an den Microcontroller übergeben wird, durch einen internen Timer etc. Zunächst prüft das im Microcontroller 10 integrierte Testprogramm die Berechtigung für die Ausführung des Selbsttests. Diese Prüfung kann je nach Ausprägung erfolgen durch Vergleich eines Istwertes mit einem im Microcontroller gespeicherten Sollwert, durch Prüfung eines Passwortes, durch Authentifikation der externen, beauftragenden Instanz (z.B. Hostrechner, Testsystem) durch den Microcontroller 10 oder in anderer geeigneter Weise.

Ist diese Prüfung erfolgreich, wird der TAP-Controller blokkiert, die Testlogik rückgesetzt und das Testprogramm startet den Selbsttest. Hierzu genügt es, wenn der Microcontroller 10 im BIST-Controller 22 ein entsprechendes Startbit setzt. Alternativ ist auch ein Assemblerbefehl "RUNBIST" denkbar, der nur bei erfolgreicher Prüfung ausführbar ist und implizit den BIST-Controller 22 startet. Bei nicht erfolgreicher Prüfung der Erlaubnis wird das Testprogramm verlassen und z.B. ein Reset ausgelöst.

Nach dem Start des Selbsttests wartet der Microcontroller 10, bis die Hardware des BIST-Controllers 22 das Testende an den Microcontroller 10 signalisiert. Diese Signalisierung kann auf vielfältige Weise durch Abfrage eines Statusbits im BIST-Controller 22, durch einen vom BIST-Controller 22 ausgelösten Interrupt, oder durch einen integrierten Timer erfolgen. Anschließend wird die BIST-Signatur durch Auslesen des Boundary Scan-Registers in das interne RAM 14 ermittelt. Danach wird das Boundary Scan-Register rückgesetzt und anschließend der TAP-Controller 24 wieder freigegeben. Durch das Rücksetzen des Boundary Scan-Registers wird verhindert, daß die Signatur (oder Teile davon) über den TAP Controller 24 auslesbar sind.

Die Prüfung der Signatur kann entweder im Microcontroller 10 selbst oder extern erfolgen.

Fig. 3 und 4 zeigen beispielhafte Implementierungen von Boundary Scan-Registerzellen 26, die zur Generierung von Testmustern (Fig. 3) bzw. der Auswertung der Testantworten (Fig. 4) verwendet werden.

Fig. 3 zeigt ein 3-Bit LFSR 30 (Linear Feedback Shift Register) als Teil einer Schaltung für eine erfindungsgemäße BS-Zelle. Die entsprechend der Erfindung zusätzlich eingefügten Schaltelemente XOR 32 und Multiplexer 34 sind fett gezeichnet. Mittels Signal LFSR werden während des Selbsttests das Boundary Scan-Schieberegister aufgetrennt und über das LFSR Testmuster generiert. Die Signale SHIFTDR und MODE sind dabei auf '1'-Pegel gesetzt. Mit jedem Takt des Signals CLOCKDR wird ein neues Testmuster erzeugt.

Fig. 4 zeigt als Beispiel einer Schaltung für die Aufnahme der Testantworten ein 3-Bit MISR (Multiple Input Signature Register) 40. Die entsprechend der Erfindung zusätzlich eingefügten Schaltelemente XOR 42 und Multiplexer sind fett gezeichnet. Mittels Signal LFSR wird während des Selbsttests das Boundary Scan-Schieberegister aufgetrennt. Das MISR 40 summiert die Testantworten aus dem Schaltungskern auf. Die Signale SHIFTDR und MODE sind dabei auf '1'-Pegel gesetzt.

Mit jedem Takt des Signals CLOCKDR wird eine weitere Testantwort aufsummiert. Das Signal UPDATEDR wird vom BIST-Controller gesperrt, damit gelangen während des Selbsttests keine Ergebnisse an die externen Pins.

Fig. 5 veranschaulicht den Signalfluß zwischen dem BIST-Controller 22, dem TAP-Controller 24, hinsichtlich der aus beiden abgeleiteten Steuersignale. Der standardgemäße TAP-Controller 24 wird durch die externen Signale TCK (Test Clock), TMS (Test Mode Select), TDI (Test Data Input) und TDO (Test Data Output) gesteuert. Die vom TAP-Controller 24 generierten internen Steuersignale (MODE_T, UPDATE_T, SHIFT_T, CLK_T) werden während des laufenden Selbsttests durch Signale aus dem BIST-Controller 22 (SHIFT_B, BIST) blockiert:
- Der BIST-Controller 22 setzt während des Selbsttests die Signale BIST, LFSR, MISR und SHIFT_B. Er selbst wird dabei über SYS_CLK, dem Systemtakt des Microcontrollers 10, getaktet.
- Signal MODE wird durch eine ODER-Verknüpfung auf '1'-Pegel gehalten, womit die in Fig. 3 und 4 vom Signal MODE angesteuerten Multiplexer 34, 44 so eingestellt werden, daß über die Eingangspins (A) keine externen Daten in den Schaltungskern (B) gelangen und so den Ablauf des Selbsttests manipulieren könnten (Fig. 3) bzw. keine (Zwischen-) Testantworten an die Ausgangspins (A) gelangen können.
- Signal UPDATEDR wird durch die UND-Verknüpfung mit negiertem Eingang auf '0'-Pegel gehalten, damit während des Selbsttests keine (Zwischen-) Testantworten an die Ausgangspins (A) gelangen können.
- Signal SHIFTDR wird für die LFSR 30 zur Bildung der Schiebefunktion auf '1'-Pegel gesetzt; für die MISR 40 ist sein Pegel ohne Bedeutung.
- Signal CLOCKDR, mit dem LFSR 30 und MISR 40 getaktet werden, wird auf SYS-CLK, dem Systemtakt des Microcontrollers 10, umgestellt.
- Signal SDO wird durch die UND-Verknüpfung mit negiertem Eingang auf '0'-Pegel gehalten, damit aus dem Boundary Scan-Schieberegister keine (Zwischen-) Testantworten an den externen Ausgang TDO des TAP-Controllers 24 gelangen können.

## Patentansprüche

1. Verfahren zum datenschützenden Selbsttest für Microcontroller, bei dem alle Schaltungselemente innerhalb des Microcontrollers (10) getestet werden können, der Ablauf des Selbsttests über die externen Pins nicht verändert werden kann und keine Zwischenergebnisse nach außen gelangen,
**dadurch gekennzeichnet,**
**daß** im Microcontroller (10) ein Boundary Scan erfolgt, daß das im Microcontroller (10) gespeicherte Testprogramm einen Selbsttest, auch Built-In Self Test genannt, darstellt und daß der Selbsttest die Register des Boundary Scan nützt, um Chip-intern Testmuster zu generieren.

2. Verfahren nach Anspruch 1,
**dadurch gekennzeichnet,**
**daß** der Boundary Scan dem IEEE-Standard 1149.1 entspricht, wobei jedoch nur die obligatorischen Testbefehle, die nach der Intention des Boundary Scans für den Fertigungstest einer Leiterplatte vorgesehen sind, implementiert sind und daß das Testprogramm im Microcontroller (10) selbst gespeichert ist.

3. Verfahren nach Anspruch 1 oder 2,
**dadurch gekennzeichnet,**
**daß** der Selbsttest die Register des Boundary Scan nützt, um Chip-intern die Testantworten zu komprimieren.

4. Verfahren nach einem der Ansprüche 1 bis 3,
**dadurch gekennzeichnet,**
**daß** der Selbsttest nicht direkt von außen gestartet wird, sondern über den Microcontroller (10).

5. Verfahren nach einem oder mehreren der vorhergehenden Ansprüche,
**dadurch gekennzeichnet,**
**daß** vor dem Start des Selbsttests die Berechtigung zur Durchführung des Selbsttests durch den Microcontroller (10) überprüft und bei fehlender Berechtigung der Selbsttest nicht gestartet wird.

6. Verfahren nach einem oder mehreren der vorhergehenden Ansprüche,
**dadurch gekennzeichnet,**
**daß** die korrekte Ausführung des Selbsttests durch den Microcontroller (10) überwacht und insbesondere keine Unterbrechung des Selbsttests zugelassen wird.

7. Verfahren nach einem der Ansprüche 1 bis 6,
**dadurch gekennzeichnet,**
**daß** durch den Microcontroller überwacht wird, daß während des Selbsttests über den Boundary Scan keine Testbefehle entsprechend dem verwendeten Standard akzeptiert werden, und insbesondere, daß ein TAP-Controller (24) logisch von den Boundary Scan-Zellen (26) abgekoppelt wird.

8. Verfahren nach Anspruch 7,
**dadurch gekennzeichnet,**
**daß**, nachdem der TAP-Controller (24) logisch-von den Boundary Scan-Zellen (26) abgekoppelt wurde, die Testlogik in einen definierten Anfangszustand gesetzt wird.

9. Verfahren nach einem der Ansprüche 1 bis 8,
**dadurch gekennzeichnet,**
**daß** die im Boundary Scan-Register gespeicherte Testantwort in einen internen Speicher gelesen und anschließend die im Boundary Scan-Register gespeicherte Testantwort gelöscht wird.

10. Verfahren nach einem oder mehreren der vorhergehenden Ansprüche,
**dadurch gekennzeichnet,**
**daß** am Testende die komprimierte Testantwort über den Microcontroller (10) ausgegeben wird.

11. Verfahren nach einem oder mehreren der vorhergehenden Ansprüche,
**dadurch gekennzeichnet,**
**daß** am Testende die komprimierte Testantwort mit einer im Festwertspeicher des Microcontrollers (10) gespeicherten Sollantwort verglichen wird.

12. Anordnung in Form einer integrierten Schaltung in einem Microcontroller (10) zum datenschützenden Selbsttest für den Microcontroller (10) mit Einrichtungen zum Starten eines Selbsttests und zu dessen interner Durchführung, wobei der Selbsttest alle wesentlichen Elemente des Microcontrollers (10) erfaßt, sowie zur Ausgabe einer entsprechenden Testanforderung,
**dadurch gekennzeichnet,**
**daß** die Anordnung Einrichtungen zur Speicherung des Selbsttestprogramms sowie Einrichtungen zur Trennung der externen Ein- und Ausgabeeinrichtungen des Microcontrollers (10) von den Einrichtungen (22) zur Durchführung des Selbsttests während der Dauer des Selbsttests aufweist.

13. Anordnung nach Anspruch 12,
**dadurch gekennzeichnet,**
**daß** der Microcontroller (10) mit einem Boundary Scan, insbesondere entsprechend IEEE-Standard 1149.1, ausgestattet ist, wobei nur die obligatorischen Testbefehle für den Fertigungstest implementiert sind und daß das Testprogramm im Microcontroller (10) selbst gespeichert ist.

14. Anordnung nach Anspruch 13,
**dadurch gekennzeichnet,**
**daß** das im Microcontroller (10) gespeicherte Testprogramm ein standardisierter Selbsttest, auch Build-In Self Test genannt, ist.

15. Anordnung nach Anspruch 13 oder 14,
**dadurch gekennzeichnet,**
**daß** eine Boundary Scan-Zelle (26) der Anordnung mit Schaltelementen XOR (32, 42) und Multiplexer (34, 36) ausgestattet ist und ausgebildet ist, um über Linear Feetback Shift Register (30) Testmuster für einen Schaltungskern (B) zu generieren, und daß das Boundary Scan-Schieberegister während des Selbsttests durch ein Signal LFSR aufgetrennt ist.

16. Anordnung nach Anspruch 15,
**dadurch gekennzeichnet,**
**daß** sie ausgebildet ist, um mit jedem Takt eines Signals CLOCKDR ein neues Testmuster zu erzeugen.

17. Anordnung nach Anspruch 15 oder 16,
**dadurch gekennzeichnet,**
**daß** das Boundary Scan-Schieberegister derart ausgebildet ist, dass es während des Selbsttests durch ein Signal MISR aufgetrennt wird, und ein Multiple Input Signature Register (40) ausgebildet ist, um die Testantworten aus dem Schaltungskern (B) aufzusummieren.

18. Anordnung nach Anspruch 17,
**dadurch gekennzeichnet,**
**daß** sie ausgebildet ist, um mit jedem Takt des Signals CLOCKDR eine weitere Testantwort aufzusummieren.

19. Anordnung nach Anspruch 18,
**dadurch gekennzeichnet,**
**daß** der BIST-Controller (22) die Register des Boundary Scans nützt, um Chip-intern die Testantworten zu komprimieren.

20. Anordnung nach einem oder mehreren der Ansprüche 14 bis 19,
**dadurch gekennzeichnet,**
**daß** der Microcontroller (10) ausgebildet ist, um den BIST-Controller (22) zu starten.

21. Anordnung nach einem oder mehreren der vorhergehenden Ansprüche 14 bis 20,
**dadurch gekennzeichnet,**
**daß** der Microcontroller (10) ausgebildet ist, um vor dem Start des Selbsttests die Berechtigung zur Durchführung des Selbsttests zu prüfen.

22. Anordnung nach einem oder mehreren der vorhergehenden Ansprüche 14 bis 21,
**dadurch gekennzeichnet,**
**daß** der Microcontroller (10) ausgebildet ist, um die korrekte Ausführung des Selbsttests zu überwachen und insbesondere keine Unterbrechungen des Selbsttests zuzulassen.

23. Anordnung nach einem oder mehreren der Ansprüche 14 bis 22,
**dadurch gekennzeichnet,**
**daß** der TAP-Controller (24) logisch von den Boundary Scan-Zellen (26) abgetrennt ist, wenn vom TAP-Controller (24) bereitgestellte interne Steuersignale (MODE_T, UPDATE_T, SHIFT_T, CLOCK_T) während des laufenden Selbsttests durch Signale (SHIFT_B, BIST) aus dem BIST-Controller (22) blockiert sind.

24. Anordnung nach Anspruch 23,
**dadurch gekennzeichnet,**
**daß** der BIST-Controller (22) ausgebildet ist, um während des Selbsttests über SYS_CLK, einen Systemtakt des Microcontrollers (10), getaktet zu werden.

25. Anordnung nach Anspruch 24,
**dadurch gekennzeichnet,**
**daß** die ansteuerbaren Multiplexer (34, 44) so eingestellt sind, daß über die Eingangspins keine externen Daten an den Schaltungskern (B) und keine Testantworten oder Zwischentestantworten an die Ausgangspins des Microcontrollers (10) gelangen.

26. Anordnung nach Anspruch 25,
**dadurch gekennzeichnet,**
**daß** sie ausgebildet ist, daß während des Selbsttests keine Testantworten oder Zwischentestantworten an die Ausgangspins des Microcontrollers (10) gelangen.

27. Anordnung nach Anspruch 26,
**dadurch gekennzeichnet,**
**daß** ein Linear Feetback Shift Register (30) ausgebildet ist, dass eine Schiebefunktion bereit gestellt ist, wenn das weitere Signal SHIFTDR auf "1"-Pegel gesetzt ist.

28. Anordnung nach Anspruch 27,
**dadurch gekennzeichnet,**
**daß** sie ausgebildet ist, dass das Signal CLOCKDR zur Taktung des Linear Feetback Shift Registers (30) und des Multiple Input Signature Registers (40) während des Selbsttests auf SYS_CLK, den Systemtakt des Microcontrollers (10), umgestellt ist.

29. Anordnung nach Anspruch 28,
**dadurch gekennzeichnet,**
**daß** das Boundary Scan-Schieberegister ausgebildet ist, dass daraus keine Testantworten oder Zwischentestantworten an einen externen Ausgang TDO des TAP-Controllers (24) gelangen.

30. Anordnung nach einem oder mehreren der vorhergehenden Ansprüche 12 bis 29,
**dadurch gekennzeichnet,**
**daß** die Testlogik derart ausgebildet ist, daß sie in einen definierten Anfangszustand gesetzt wird, wenn der im IEEE-Standard 1149.1 angegebene TAP-Controller (24) logisch von den Boundary Scan-Zellen (26) abgekoppelt ist.

## Claims

1. Method for the data-protecting self-test for microcontrollers, in which all of the circuit elements within the microcontroller (10) can be tested, the course of the self-test cannot be altered via the external pin, and no intermediate results are passed to the outside,
**characterized**
**in that** the microcontroller (10) performs a boundary scan, in that the test program stored in the microcontroller (10) is a self-test, also referred to as a Built-In Self-Test, and in that the self-test uses the registers of the boundary scan in order to generate test patterns within the chip.

2. Method according to Claim 1,
**characterized**
**in that** the boundary scan is based on IEEE standard 1149.1, but only the obligatory test instructions provided for the production test on a printed circuit board, in line with the intention of the boundary scan, are implemented, and in that the test program is stored in the microcontroller (10) itself.

3. Method according to Claim 1 or 2,
**characterized**
**in that** the self-test uses the registers of the boundary scan in order to compress the test responses within the chip.

4. Method according to one of Claims 1 to 3,
**characterized**
**in that** the self-test is not started directly from the outside, but rather by means of the microcontroller (10).

5. Method according to one or more of the preceding claims,
**characterized**
**in that**, before the start of the self-test, the authorization to perform the self-test is checked by the microcontroller (10), and the self-test is not started if authorization is missing.

6. Method according to one or more of the preceding claims,
**characterized**
**in that** correct execution of the self-test is monitored by the microcontroller (10), and, in particular, interruption of the self-test is not allowed.

7. Method according to one of Claims 1 to 6,
**characterized**
**in that** the microcontroller checks that no test instructions using the boundary scan are accepted during the self-test in line with the standard used and, in particular, that a TAP controller (24) is decoupled from the boundary scan cells (26) by means of logic.

8. Method according to Claim 7,
**characterized**
**in that**, after the TAP controller (24) has been decoupled from the boundary scan cells (26) by means of logic, the test logic is put into a defined initial state.

9. Method according to one of Claims 1 to 8,
**characterized**
**in that** the test response stored in the boundary scan register is read into an internal memory, and the test response stored in the boundary scan register is then erased.

10. Method according to one or more of the preceding claims,
**characterized**
**in that**, at the end of the test, the compressed test response is output by means of the microcontroller (10).

11. Method according to one or more_ of the preceding claims,
**characterized**
**in that**, at the end of the test, the compressed test response is compared with a nominal response stored in the read only memory of the microcontroller (10).

12. Arrangement in the form of an integrated circuit in a microcontroller (10) for the data-protecting self-test for the microcontroller (10), having devices for starting a self-test and for performing it internally, where the self-test covers all the fundamental elements of the microcontroller (10), and for outputting a corresponding test demand,
**characterized**
**in that** the arrangement has devices for storing the self-test program and devices for isolating the external input and output devices of the microcontroller (10) from the devices (22) for performing the self-test over the duration of the self-test.

13. Arrangement according to Claim 12,
**characterized**
**in that** the microcontroller (10) is equipped with a boundary scan, in particular based on IEEE standard 1149.1, with only the obligatory test instructions for the production test being implemented, and in that the test program is stored in the microcontroller (10) itself.

14. Arrangement according to Claim 13,
**characterized**
**in that** the test program stored in the microcontroller (10) is a standardized self-test, also referred to as a Built-In Self-Test.

15. Arrangement according to Claim 13 or 14,
**characterized**
**in that** a boundary scan cell (26) in the arrangement is equipped with switching elements XOR (32, 42) and multiplexers (34, 36) and is designed to use Linear Feedback Shift Register (30) to generate test patterns for a circuit core (B), and in that the boundary scan shift register is split by a signal LFSR during the self-test.

16. Arrangement according to Claim 15,
**characterized**
**in that** it is designed to produce a new test pattern upon each clock cycle of a signal CLOCKDR.

17. Arrangement according to Claim 15 or 16 **characterized**
**in that** the boundary scan shift register is designed to be split by a signal MISR during the self-test, and a Multiple Input Signature Register (40) is designed to sum the test responses from the circuit core (B).

18. Arrangement according to Claim 17,
**characterized**
**in that** it is designed to sum another test response upon each clock cycle of the signal CLOCKDR.

19. Arrangement according to Claim 18,
**characterized**
**in that** the BIST controller (22) uses the registers of the boundary scan to compress the test responses within the chip.

20. Arrangement according to one or more of Claims 14 to 19,
**characterized**
**in that** the microcontroller (10) is designed to start the BIST controller (22).

21. Arrangement according to one or more of the preceding Claims 14 to 20,
**characterized**
**in that** the microcontroller (10) is designed to check the authorization to perform the self-test before the start of the self-test.

22. Arrangement according to one or more of the preceding Claims 14 to 21,
**characterized**
**in that** the microcontroller (10) is designed to monitor the correct execution of the self-test and, in particular, to forbid interruption of the self-test.

23. Arrangement according to one or more of Claims 14 to 22,
**characterized**
**in that** the TAP controller (24) is isolated from the boundary scan cells (26) by means of logic when internal control signals (MODE_T, UPDATE_T, SHIFT_T, CLOCK_T) provided by the TAP controller (24) are blocked by signals (SHIFT_B, BIST) from the BIST controller (22) while the self-test is running.

24. Arrangement according to Claim 23,
**characterized**
**in that** the BIST controller (22) is designed to be clocked by means of SYS_CLK, a system clock of the microcontroller (10), during a self-test.

25. Arrangement according to Claim 24,
**characterized**
**in that** the actuable multiplexers (34, 44) are set such that no external data is passed to the circuit core (B) and no test responses or intermediate test responses are passed to the output pins of the microcontroller (10) via the input pins.

26. Arrangement according to Claim 25,
**characterized**
**in that** it is designed such that no test responses or intermediate test responses are passed to the output pins of the microcontroller (10) during the self-test.

27. Arrangement according to Claim 26,
**characterized**
**in that** a Linear Feedback Shift Register (30) is designed such that a shift function is provided when the further signal SHIFTDR is set to the "1" level.

28. Arrangement according to Claim 27,
**characterized**
**in that** it is designed such that, during the self-test, the signal CLOCKDR used to clock the Linear Feedback Shift Register (30) and the Multiple Input Signature Register (40) is changed over to SYS-CLK, the system clock of the microcontroller (10).

29. Arrangement according to Claim 28,
**characterized**
**in that** the boundary scan shift register is designed such that no test responses or intermediate test responses are passed to an external output TDO of the TAP controller (24) from the boundary scan shift register.

30. Arrangement according to one or more of the preceding Claims 12 to 29,
**characterized**
**in that** the test logic is designed to be put into a defined initial state when the TAP controller (24) specified in IEEE standard 1149.1 is decoupled from the boundary scan cells (26) by means of logic.

## Revendications

1. Procédé de test automatique de protection des données pour des microcontrôleurs, dans lequel tous les éléments de circuit à l'intérieur du microcontrôleur (10) peuvent être testés, l'exécution du test automatique ne peut pas être modifiée par l'intermédiaire des broches externes et aucun résultat intermédiaire n'arrive à l'extérieur,
**caractérisé par le fait qu'**il s'effectue un balayage de périphérie ou Boundary Scan dans le microcontrôleur (10), que des programmes de test mémorisés dans le microcontrôleur (10) représente un test automatique, aussi appelé Built-In Self Test, et que le test automatique utilise les registres du Boundary Scan pour produire des motifs de test de manière interne à la puce.

2. Procédé selon la revendication 1,
**caractérisé par le fait que** le Boundary Scan correspond au standard IEEE 1149.1, seules les instructions de test obligatoires qui sont prévues à l'intention du Boundary Scan pour le test de fabrication d'une carte de circuits imprimés étant toutefois mises en oeuvre, et que le programme de test est mémorisé dans le microcontrôleur (10) lui-même.

3. Procédé selon la revendication 1 ou 2,
**caractérisé par le fait que** le test automatique utilise les registres du Boundary Scan pour comprimer les réponses de test de manière interne à la puce.

4. Procédé selon l'une des revendications 1 à 3,
**caractérisé par le fait que** le test automatique n'est pas démarré directement de l'extérieur mais par l'intermédiaire du microcontrôleur (10).

5. Procédé selon l'une ou plusieurs des revendications précédentes,
**caractérisé par le fait que**, avant le démarrage du test automatique, l'autorisation pour la mise en oeuvre du test automatique est vérifiée par le microcontrôleur (10) et, en l'absence d'une autorisation, le test automatique n'est pas démarré.

6. Procédé selon l'une ou plusieurs des revendications précédentes,
**caractérisé par le fait que** l'exécution correcte du test automatique est surveillée par le microcontrôleur (10) et, en particulier, aucune interruption du test automatique n'est autorisée.

7. Procédé selon l'une des revendications 1 à 6,
**caractérisé par le fait que** le microcontrôleur surveille qu'aucune instruction de test selon le standard utilisé n'est acceptée pendant le test automatique par l'intermédiaire du Boundary Scan et notamment qu'un contrôleur de port d'accès au test TAP (24) est découplé logiquement des cellules de Boundary Scan (26).

8. Procédé selon la revendication 7,
**caractérisé par le fait que**, après que le contrôleur TAP (24) a été découplé logiquement des cellules Boundary Scan (26), la logique de test est mise dans un état initial défini.

9. Procédé selon l'une des revendications 1 à 8,
**caractérisé par le fait que** la réponse de test mémorisée dans le registre de Boundary Scan est lue dans une mémoire interne puis la réponse de test mémorisée dans le registre de Boundary Scan est effacée.

10. Procédé selon l'une ou plusieurs des revendications précédentes,
**caractérisé par le fait que**, à la fin du test, la réponse de test comprimée est délivrée en sortie par l'intermédiaire du microcontrôleur (10).

11. Procédé selon l'une ou plusieurs des revendications précédentes,
**caractérisé par le fait que**, à la fin du test, la réponse de test comprimée est comparée à une réponse de consigne mémorisée dans la mémoire morte du microcontrôleur (10).

12. Circuit sous la forme d'un circuit intégré dans un microcontrôleur (10) pour le test automatique de protection des données pour le microcontrôleur (10), avec des dispositifs pour le démarrage d'un test automatique et pour la mise en oeuvre interne de celui-ci, le test automatique détectant tous les éléments essentiels du microcontrôleur (10), ainsi que pour la sortie d'une demande de test correspondante,
**caractérisé par le fait que** le circuit comporte des dispositifs pour la mémorisation du programme de test automatique ainsi que des dispositifs pour la séparation entre les dispositifs d'entrée et de sortie externes du microcontrôteur (10) et les dispositifs (22) pour la mise en oeuvre du test automatique pendant la durée du test automatique.

13. Circuit selon la revendication 12,
**caractérisé par le fait que** le microcontrôleur (10) est équipé d'un balayage de périphérie ou Boundary Scan, notamment selon le standard IEEE 1149.1, seules les instructions de test obligatoires pour le test de fabrication étant mises en oeuvre, et que le programme de test est mémorisé dans le microcontrôleur (10) lui-même.

14. Circuit selon la revendication 13,
**caractérisé par le fait que** le programme de test mémorisé dans le microcontrôleur (10) est un test automatique standard, aussi appelé Built-In Self Test.

15. Circuit selon la revendication 13 ou 14,
**caractérisé par le fait qu'**une cellule de Boundary Scan (26) du circuit est équipée d'éléments de circuit XOR (32, 42) et de multiplexeurs (34, 36) et est conçue pour produire des motifs de test pour un noyau de circuit (B) par l'intermédiaire de registres à décalage linéaires ou Linear Feedback Shift Register (30) et que le registre à décalage de Boundary Scan pendant le test automatique est coupé par un signal LFSR.

16. Circuit selon la revendication 15,
**caractérisé par le fait qu'**il est conçu pour produire un nouveau motif de test à chaque cycle d'un signal CLOCKDR.

17. Circuit selon la revendication 15 ou 16,
**caractérisé par le fait que** le registre à décalage de Boundary Scan est conçu de telle sorte que, pendant le test automatique, il est coupé par un signal MISR et qu'un registre de signature à entrées multiples ou Multiple Input Signature Register (40) est conçu pour cumuler les réponses de test du noyau de circuit (B).

18. Circuit selon la revendication 17,
**caractérisé par le fait qu'**il est conçu pour cumuler une autre réponse de test à chaque cycle du signal CLOCKDR.

19. Circuit selon la revendication 18,
**caractérisé par le fait que** le contrôleur BIST (22) utilise les registres du Boundary Scan pour comprimer les réponses de test de manière interne à la puce.

20. Circuit selon l'une ou plusieurs des revendications 14 à 19,
**caractérisé par le fait que** le microcontrôleur (10) est conçu pour démarrer le contrôleur BIST (22).

21. Circuit selon l'une ou plusieurs des revendications 14 à 20,
**caractérisé par le fait que** le microcontrôleur (10) est conçu pour vérifier l'autorisation de mise en oeuvre du test automatique avant le démarrage du test automatique.

22. Circuit selon l'une ou plusieurs des revendications 14 à 21,
**caractérisé par le fait que** le microcontrôleur (10) est conçu pour surveiller l'exécution correcte du test automatique et en particulier pour n'autoriser aucune interruption du test automatique.

23. Circuit selon l'une ou plusieurs des revendications 14 à 22,
**caractérisé par le fait que** le contrôleur TAP (24) est séparé logiquement des cellules de Boundary Scan (26) lorsque des signaux de commande internes (MODE_T, UPDATE_T, SHIFT_T, CLOCK_T) fournis par le contrôleur TAP (24) sont bloqués pendant le test automatique en cours par des signaux (SHIFT_B, BIST) provenant du contrôleur BIST (22).

24. Circuit selon la revendication 23,
**caractérisé par le fait que** le contrôleur BIST (22) est conçu pour être soumis à une horloge pendant le test automatique par l'intermédiaire de SYS_CLK, une horloge de système du microcontrôleur (10).

25. Circuit selon la revendication 24,
**caractérisé par le fait que** les multiplexeurs commandables (34, 44) sont réglés de telle sorte qu'aucune donnée externe n'arrive au noyau de circuit (B) par l'intermédiaire des broches d'entrée et aucune réponse de test ou réponse de test intermédiaire n'arrive aux broches de sortie du microcontrôleur (10).

26. Circuit selon la revendication 25,
**caractérisé par le fait qu'**il est conçu de telle sorte que, pendant le test automatique, aucune réponse de test ou réponse de test intermédiaire n'arrive aux broches de sortie du microcontrôleur (10).

27. Circuit selon la revendication 26,
**caractérisé par le fait qu'**un Linear Feedback Shift Register (30) est conçu de manière à fournir une fonction de décalage lorsque l'autre signal SHIFTDR est mis au niveau "1 ".

28. Circuit selon la revendication 27,
**caractérisé par le fait qu'**il est conçu de telle sorte que le signal CLOCKDR servant d'horloge au Linear Feedback Shift Register (30) et au Multiple Input Signature Register (40) est réglé pendant le test automatique sur SYS_CLK, l'horloge de système du microcontrôleur (10).

29. Circuit selon la revendication 28,
**caractérisé par le fait que** le registre à décalage de Boundary Scan est conçu de telle sorte que, à partir de là, aucune réponse de test ou réponse de test intermédiaire n'arrive à une sortie externe TDO du contrôleur TAP (24).

30. Circuit selon l'une ou plusieurs des revendications précédentes 12 à 29,
**caractérisé par le fait que** la logique de test est conçue de telle sorte qu'elle est mise dans un état initial défini lorsque le contrôleur TAP (24) donné dans le standard IEEE 1149.1 est découplé logiquement des cellules de Boundary Scan (26).
